# EUROPEAN PATENT APPLICATION

(11) **EP 1 458 068 A2**
(43) Date of publication of application: **15.09.2004**
(21) Application number: 04005122.9
(22) Date of filing: 04.03.2004
(51) Int. Cl.: H01S 5/042

(54) **Driving circuit for semiconductor laser**

(30) Priority: 13.03.2003 JP 2003068648
(71) Applicant: ALPS ELECTRIC CO., LTD., Tokyo 145-8501 (JP)
(72) Inventor: Saito, Kyozo, Tokyo, 145-8501 (JP)
(74) Representative: Klunker . Schmitt-Nilson . Hirsch

(57) **Abstract**

A semiconductor laser, a bias-current supplying unit (3) for supplying a bias current to the semiconductor laser, and a modulation-current supplying unit (3) for supplying a modulation current to the semiconductor laser, based on an input modulation signal, are provided. The bias current is supplied at least over a time period during the modulation current is supplied and not supplied over a time period during the modulation-current supplying is stopped.

## Description

### BACKGROUND OF THE INVENTION

### 1. Field of the Invention

The present invention relates to a driving circuit for a semiconductor laser.

### 2. Description of the Related Art

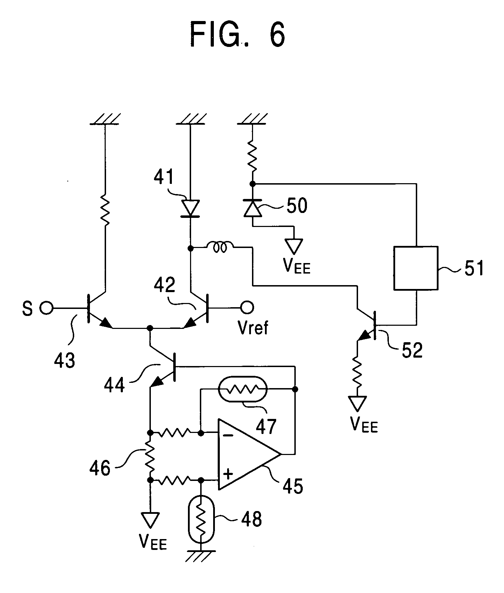

FIG. 6 illustrates a known driving circuit of for a semiconductor laser. A reference voltage Vref is applied to a base of a transistor 42 provided for feeding a modulation current through a semiconductor laser 41. An emitter of the transistor 42 is connected to an emitter of a transistor 43. A modulation pulse signal is input to a base of the transistor 43. These two emitters are connected to a collector of a transistor 44 and an operational amplifier 45 is connected between the base and emitter of the transistor 44. A voltage of an emitter resistor 46 of the transistor 44 is input to the operational amplifier 45. Then, a thermistor 47 provides negative feedback to an inverting input terminal (-) and a non-inverting input terminal (+) is grounded through a thermistor 48.

According to the above-described configuration, the transistors 42 and 43 are alternately turned on and off by successive pulse signals, and a modulation current passes through the semiconductor laser 41. Since the thermistors 47 and 48 are connected to the operational amplifier 45, the amount of the modulation current passing through the semiconductor laser 41 increases, as temperature rises. Subsequently, even though the efficiency of the semiconductor laser 41 decreases, the light output thereof becomes constant.

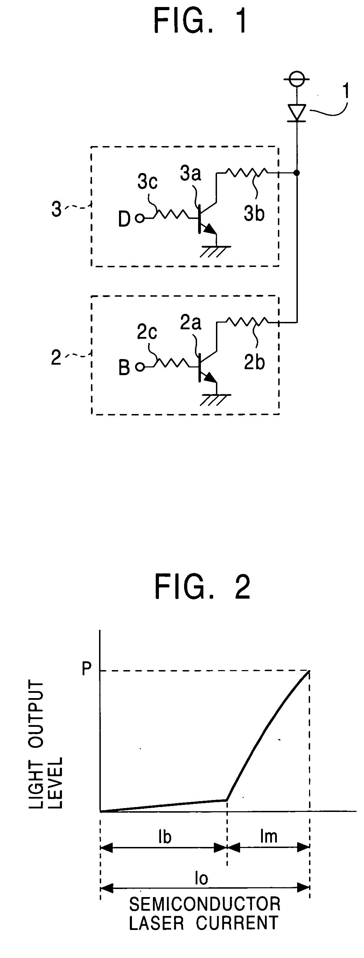

Part of the light output of the semiconductor laser 41 is detected by a light-receiving element 50. The detected voltage is input to a light-output control circuit 51. This light-output control circuit 51 drives a transistor 52 for feeding a bias current through the semiconductor laser 41 so that the light output of the semiconductor laser 41 becomes constant irrespective of the ambient temperature. That is to say, if the detected voltage drops, as the efficiency of the semiconductor laser 41 decreases due to the increased ambient temperature, the light-output control circuit 51 controls the transistor 52 for increasing the amount of bias current, so as to compensate for the dropped voltage, as shown in Japanese Patent Unexamined Application Publication No. 5-259563 illustrated in FIG. 1.

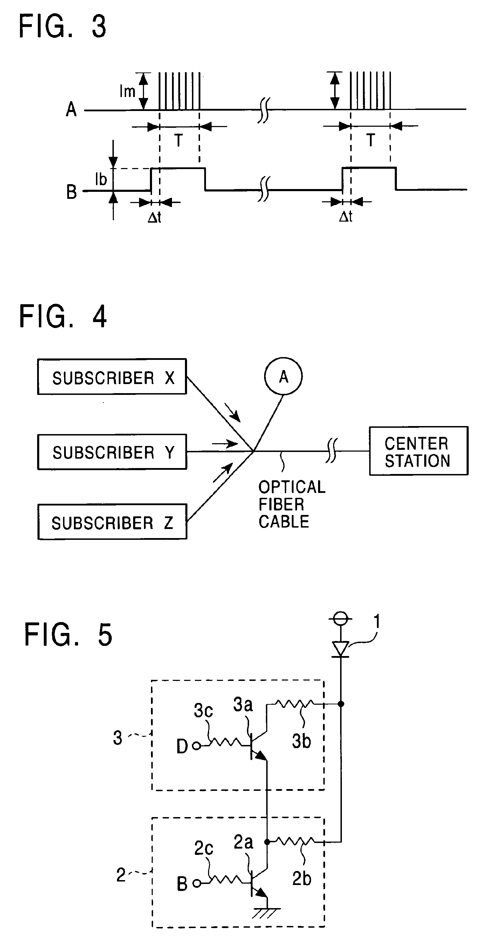

When the above-described driving circuit is used in a passive optical network (PON) system according to a time-division method, where the PON system has a common center to which a plurality of subscriber is connected through a shareable optical fiber, optical signals including optical signals corresponding to the bias current are supplied to a point where optical fibers of the subscribers join one another (see point A in FIG. 4). In this case, the amount of light output due to the bias current increases, and the difference between the level of the above-described light output and that of light output obtained where modulation signals (modulation pulse signals) are input decreases. Subsequently, the extinction ratio deteriorates, which hampers detection of signals on the reception side.

Where the modulation pulse signals are input intermittently in a burst fashion, modulation currents do not pass through the semiconductor laser over time periods during the modulation pulse signals are not input. Subsequently, since a current does not pass through the light receiving element 50 over the above-described time periods, the light-output control circuit 51 passes a maximum current through the semiconductor laser 41, whereby the semiconductor laser 41 is destroyed. Therefore, the above-described driving circuit cannot be used in burst mode.

### SUMMARY OF THE INVENTION

Accordingly, it is an object of the present invention to provide a driving circuit for a semiconductor laser for detecting a signal correctly by decreasing deterioration of the extinction ratio due to a bias current. This driving circuit is suitable for time-division communication performed by using the PON system or the like.

For solving the above-described problems, a driving circuit for a semiconductor laser according to a first aspect of the present invention is provided. This driving circuit comprises a bias-current supplying unit for supplying a bias current to the semiconductor laser, and a modulation-current supplying unit for supplying a modulation current to the semiconductor laser, based on an input modulation signal. The bias-current supplying unit is configured so that the bias current is supplied over a time period during the modulation current is supplied. Further, supplying the bias current is stopped over a time period during the modulation-current supplying is stopped. Therefore, where a plurality of the driving circuits is used, the level of optical signals due to the bias current of all optical signals transmitted to an optical-fiber cable becomes low. Consequently, signal detection on the reception side can be performed without an error.

Preferably, supplying the bias current is started at predetermined time before time when supplying the modulation current is started. Therefore, the semiconductor laser can emit light in a short time elapsed after the modulation-current supplying is started. Subsequently, pulse-wave distortion caused by light-emission delay reduces.

Preferably, the bias-current supplying unit has at least one first transistor connected in series with the semiconductor laser. The modulation-current supplying unit may have at least one second transistor connected in series with the semiconductor laser. At least one voltage may be applied to a base of the first transistor for passing the bias current therethrough. Further, the modulation signal may be input to a base of the second transistor. Subsequently, the bias current and the modulation current can be easily supplied, and time periods for supplying these currents can be easily set.

Preferably, the first and second transistors are formed as NPN transistors, where collectors of the first and second transistors are connected to the semiconductor laser and where emitters of the two transistors are grounded. Thus, the configuration of the driving circuit can be simplified.

Preferably, the modulation current passing through the second transistor passes through the first transistor. Therefore, the modulation-current supplying can be stopped over a time period during the bias-current supplying performed by the first transistor is stopped.

Preferably, the first and second transistors are formed as NPN transistors. Collectors of the first and second transistors may be connected to the semiconductor laser, an emitter of the first transistor may be grounded, and the collector of the second transistor may be connected to the collector of the first transistor. Therefore, the modulation current can pass through the first transistor used for the bias current.

### BRIEF DESCRIPTION OF THE DRAWINGS

FIG. 1 is a circuit diagram illustrating an example driving circuit for a semiconductor laser according to the present invention;
FIG. 2 illustrates a light-output characteristic of the semiconductor laser;
FIG. 3 shows timing charts for a modulation current and a bias current that are supplied from the driving circuit to the semiconductor laser;
FIG. 4 illustrates an example communication system using the driving circuit;
FIG. 5 is a circuit diagram illustrating another example driving circuit for a semiconductor laser according to the present invention; and
FIG. 6 is a circuit diagram illustrating a known driving circuit for a semiconductor laser.

### DESCRIPTION OF THE PREFERRED EMBODIMENTS

An example driving circuit for a semiconductor laser according to the present invention will now be described with reference to FIGs. 1 to 3. FIG. 1 illustrates the configuration of the driving circuit, FIG. 2 illustrates a light-output characteristic of the semiconductor laser, and FIG. 3 shows timing charts for modulation signals and bias voltages. FIG. 5 illustrates another example driving circuit for the semiconductor laser.

In FIG. 1, a predetermined voltage is applied to an anode of a semiconductor laser diode (hereinafter referred to as a semiconductor laser) 1. A bias-current supplying unit 2 for supplying a bias current to the semiconductor laser 1 has a first transistor (NPN type) 2a connected in series with the semiconductor laser 1. More specifically, a collector of the first transistor 2a is connected to a cathode of the semiconductor laser 1 via a resistor 2b for restricting the bias current, and an emitter of the first transistor 2a is grounded. A bias voltage B for passing the bias current is applied to a base of the first transistor 2a via a resistor 2c for restricting a base current.

A modulation-current supplying unit 3 for supplying a modulation current (a modulation pulse current) to the semiconductor laser 1 has a second transistor (NPN type) 3a connected in series with the semiconductor laser 1. More specifically, a collector of the second transistor 3a is connected to the cathode of the semiconductor laser 1 via a resistor 3b for restricting the modulation current, and an emitter of the second transistor 3a is grounded. Data D (a modulation pulse voltage) for passing the modulation current is input to a base of the second transistor 3a via a resistor 3c for restricting a base current.

The light-output level P of the semiconductor laser 1 is determined in accordance with all the currents (Io) passing through the semiconductor laser 1. Usually, a current prior to and subsequent to starting light emission (a bias current Ib) is made to pass, as shown in FIG. 2, and a pulse modulation current (Im) is superimposed thereon. Subsequently, light emission can be achieved in a short time. A light output from the semiconductor laser 1 is transmitted to a center station or the like connected thereto through an optical fiber cable.

As the data D is input to the modulation-current supplying unit 3, a modulation current supplied to the semiconductor laser 1 passes correspondingly. More specifically, the modulation current passes over a time period T in burst fashion during the data D is input, as shown in time chart A in FIG. 3. That is to say, the flow of the modulation current occurs intermittently. Therefore, the bias-current supplying unit 2 is configured so as to make the bias current, which is superimposed on the modulation current, flow over the time periods during the data D is input and intermittently, as shown in FIG. 3B. That is to say, when the time period where the data D is input ends, the bias current does not pass. However, it is effective to supply a bias current at predetermined time earlier than the time of starting modulation-current supplying by Δt for reducing the time between supplying the modulation current to the semiconductor laser 1 and starting light emission.

Where a plurality of subscribers X to Z has the above-described driving circuit and is connected to a common center station through an optical-fiber cable, as shown in FIG. 4, light outputs corresponding to the modulation currents and the bias currents shown in FIG. 3 are transmitted from each of the subscribers to the optical-fiber cable in time-division manner. Since the bias currents are in synchronization with the modulation currents and generated in the time-division manner, part of the light outputs transmitted to the optical-fiber cable, the part being dependent on the bias currents, is transmitted from only one of the subscribers. Accordingly, it becomes possible to reduce the level of noise (a light output generated by the bias currents) generated at the time where the center station detects signals. Consequently, the signal detection can be achieved correctly.

Fig. 5 illustrates another example driving circuit for a semiconductor laser according to the present invention. The same parts as those shown in FIG. 1 are designated by the same reference numerals. In the bias-current supplying unit 2, the collector of the first transistor 2a is connected to the semiconductor laser 1 and the emitter is grounded. However, the emitter of the second transistor 3a of the modulation-current supplying unit 3 is not grounded, but connected to the collector of the first transistor 2a. Subsequently, a modulation current passing through the second transistor 3a flows into the first transistor 2a. The configuration of other parts is the same as that of FIG. 1. According to the above-described configuration, if the first transistor 2a is turned off so as to stop supplying bias currents, the second transistor 3a would be inevitably turned off at the same time. Therefore, the settings on timing of turning the first transistor 2a off become the same as those of the second transistor 3a.

The first transistor 2a in the bias-current supplying unit 2 and the second transistor 3a in the modulation-current supplying unit 3 may be of PNP type in place of the NPN type. Further, each of the first transistor 2a and the second transistor 3a is not necessarily be a bipolar transistor, but may be a field-effect transistor (FET). Still further, each of the transistors may be formed as a switching element of another type.

## Claims

1. A driving circuit for a semiconductor laser comprising:
a bias-current supplying unit for supplying a bias current to the semiconductor laser; and
a modulation-current supplying unit for supplying a modulation current to the semiconductor laser, based on an input modulation signal,
wherein the bias-current supplying unit is configured so that the bias current is supplied over a time period during the modulation current is supplied and supplying the bias current is stopped over a time period during the modulation-current supplying is stopped.

2. A driving circuit for a semiconductor laser according to Claim 1, wherein supplying the bias current is started at predetermined time before time when supplying the modulation current is started.

3. A driving circuit for a semiconductor laser according to Claim 1 or 2, wherein the bias-current supplying unit has at least one first transistor connected in series with the semiconductor laser, wherein the modulation-current supplying unit has at least one second transistor connected in series with the semiconductor laser, wherein at least one voltage is applied to a base of the first transistor for passing the bias current therethrough, and wherein the modulation signal is input to a base of the second transistor

4. A driving circuit for a semiconductor laser according to Claim 3, wherein the first and second transistors are formed as NPN transistors, where collectors of the first and second transistors are connected to the semiconductor laser and where emitters of the two transistors are grounded.

5. A driving circuit for a semiconductor laser according to Claim 3 or 4, wherein the modulation current passing through the second transistor passes through the first transistor.

6. A driving circuit for a semiconductor laser according to Claim 5, wherein the first and second transistors are formed as NPN transistors, where collectors of the first and second transistors are connected to the semiconductor laser, where an emitter of the first transistor is grounded, and where the collector of the second transistor is connected to the collector of the first transistor.
